Europäisches Patentamt

European Patent Office

Office européen des brevets

(19)

(11) Veröffentlichungsnummer: **0 259 605**

**A1**

(12) # EUROPÄISCHE PATENTANMELDUNG

(21) Anmeldenummer: **87111271.0**

(22) Anmeldetag: **04.08.87**

(51) Int. Cl.⁴: **H01L 21/225** , H01L 21/82

(30) Priorität: **29.08.86 DE 3629393**

(43) Veröffentlichungstag der Anmeldung:
**16.03.88 Patentblatt 88/11**

(84) Benannte Vertragsstaaten:
**AT DE FR GB IT NL**

(71) Anmelder: **Siemens Aktiengesellschaft Berlin und München**
**Wittelsbacherplatz 2**
**D-8000 München 2(DE)**

(72) Erfinder: **Becker, Frank, Dr.rer.nat.**
**Neufriedenheimer Strasse 67 a**
**D-8000 München 70(DE)**
Erfinder: **Hopf, Erwin, Dipl.-Ing.**
**Grünauer Allee 14**
**D-8025 Unterhaching(DE)**

(54) **Verfahren zum Erzeugen einer definierten Dotierung in Seitenwänden und Böden von in Halbleitersubstrate eingeätzten Gräben.**

(57) Die Erfindung betrifft ein Verfahren zum Erzeugen einer definierten Dotierung (5) in Seitenwänden und Böden von in Halbleitersubstrate (1) eingeätzten Gräben (6) durch Ausdiffusion des Dotierstoffes (4) aus einer Borsilikatglasschicht (3), welche durch Zersetzung von organischen, Bor, Silizium und Sauerstoff enthaltenden Verbindungen aus der Gasphase in den Gräben (6) abgeschieden und nach der Ausdiffusion (4) entfernt wird. Unter Verwendung von Tetraethylorthosilikat und Trimethylborat als organische Verbindungen wird ein überall gleichmäßiges Bordotierungsprofil (5) in den Gräben (6) erzielt, das insbesondere in Richtung Grabenboden nicht abnimmt; dies ist bei der Herstellung von Grabenkondensatoren für DRAMs von großer Bedeutung.

FIG 2

## Verfahren zum Erzeugen einer definierten Dotierung in Seitenwänden und Böden von in Halbleitersubstrate eingeätzten Gräben.

Die Erfindung betrifft ein Verfahren zum Erzeugen einer definierten Dotierung in Seitenwänden und Böden von in Halbleitersubstrate eingeätzten Gräben durch Ausdiffusion von Dotierstoff aus einer in diesen Gräben abgeschiedenen, diesen Dotierstoff enthaltenden Schicht und anschließende Entfernung derselben.

Derartige dotierte Gräben bilden die Grundlage von Kondensatorspeicherzellen (Trench-Zellen), die wegen ihres geringen Platzbedarfs in höchstintegrierten Halbleiterschaltungen als DRAM-Speicher verwendet werden (dynamic random excess memory = dynamische Speicherzelle mit wahlfreiem Zugriff), um so einen weiteren Flächengewinn zu erzielen.

Im Bereich dieser Grabenzellen wird eine hohe Dotierung benötigt, die bisher durch eine p-Wannentechnik erzeugt wurde. Dabei werden in einem elektrischen Feld beschleunigte Ionen des Dotierstoffes in mit einer Maskentechnik definierte Bereiche des Halbleitersubstrates implantiert.

Eine Methode, in den Wänden und Böden von Trench-Zellen eine Phosphordotierung zu erzeugen, wird zum Beispiel in einem Aufsatz von T. Morie et al in IEEE 1983, Seiten 411 bis 414, beschrieben. Hierzu wird in den im Substrat geätzten Gräben ein Phosphorsilikatglas (PSG) durch chemische Zersetzung von Phosphin ($PH_3$) und Silan ($SiH_4$) in einer Sauerstoffatmosphäre abgeschieden, aus welcher der Phosphor bei hohen Temperaturen durch Ausdiffusion in das Substrat überführt wird.

Diese bekannten Verfahren weisen eine Reihe von Nachteilen auf. So wird für die p-Wannentechnik ein extra Maskenschritt benötigt. Zum Erreichen großer Wannentiefen ist außerdem ein viele Stunden dauernder Hochtemperaturprozeß erforderlich, der trotzdem zu einer zum Grabenboden hin stark abnehmenden Dotierstoffkonzentration führt. Ein ähnlich ungünstiger Konzentrationsgradient wird bei der Diffusion aus PSG-Schichten nach dem oben erwähnten Verfahren als Folge einer mit zunehmender Grabentiefe dünner werdenden PSG-Schicht erzielt. Dieser Gradient verringert die maximal erreichbare Kapazität in der späteren Grabenzelle und führt zu einer hohen Empfindlichkeit gegenüber Leckströmen.

Aufgabe der vorliegenden Erfindung ist es nun, ein Dotierverfahren zur Anwendung in Gräben anzugeben, das eine hohe Dotierung mit Bor erlaubt, einfach durchzuführen und gut zu kontrollieren ist, ohne dabei die Nachteile der bekannten Verfahren zu zeigen.

Die Aufgabe wird bei einem Verfahren der eingangs genannten Art erfindungsgemäß dadurch gelöst, daß die Schicht als Borsilikatglas (BSG) durch thermische Zersetzung aus der Gasphase von organischen Silizium, Sauerstoff und Bor enthaltenden Verbindungen abgeschieden wird.

Dabei liegt es im Rahmen der Erfindung, daß die Schicht durch Zersetzung der organischen Verbindungen Tetraethylorthosilikat (TEOS = $(C_2H_5O)_4$ Si) und Trimethylborat (TMB = $(CH_3O)_3$ B) bei einer Temperatur von 600 bis 700°C und einem Druck von 0,1 bis 2 mbar erzeugt wird und die Ausdiffusion bei 900 bis 1050°C erfolgt.

Weitere Ausgestaltungen der Erfindung sind den Unteransprüchen zu entnehmen.

Das Verfahren nach der Lehre der Erfindung weist gegenüber bekannten Techniken mehrere Vorteile auf:

1. Durch die gute Kantenbedeckung der BSG-Schicht nach dem TEOS-Prozeß wird eine Dünnung der Schicht an kritischen Stellen vermieden und somit für eine gleichmäßige Stärke der Dotierstoffquelle gesorgt.

2. Auch bei einem hohen Aspektverhältnis (zum Beispiel 5µm tiefe und 1 µm breite Gräben) nimmt die Schichtdicke und somit die Dotierstoffkonzentration in Richtung Grabenboden nicht ab.

3. Es läßt sich ein gleichmäßiges Dotierprofil von einer optimalen Eindringtiefe der Boratome von 0,5 µm erzeugen.

4. Über den Borgehalt der BSG-Schicht, die Temperatur und die Temperzeit läßt sich die Stärke und das Profil der Dotierung leicht kontrollieren.

5. Das Verfahren ist einfach und schnell durchzuführen und außerdem selbstjustierend, da kein zusätzlicher Maskenschritt erforderlich ist.

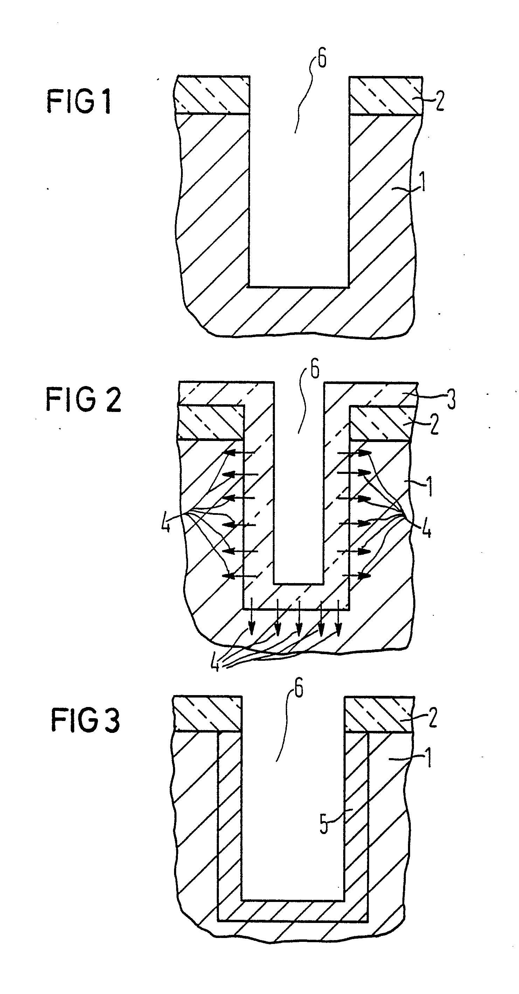

Anhand eines Ausführungsbeispiels und der Figuren 1 bis 3, die im Schnittbild die wesentlichsten Verfahrensschritte darstellen, wird die Erfindung näher erläutert. In allen Figuren gelten für gleiche Teile die gleichen Bezugszeichen.

Dabei zeigt Figur 1 einen, in ein mit einer Siliziumoxidschicht 2 bedecktes, aus Silizium bestehendes Substrat 1 eingeätzten Graben 6 von beispielsweise 5 µm Tiefe und 1 µm Breite.

In Figur 2 ist die in den Graben 6 abgeschiedene BSG-Schicht 3 zu erkennen, die durch Zersetzung aus der Gasphase von TEOS und TMB bei einer Temperatur von 650°C und einem Druck von 0,5 mbar abgeschieden wird. Die Zusammensetzung der BSG-Schicht wird über die Strömungsgeschwindigkeiten der Trägergase Stickstoff oder Sauerstoff bzw. durch die Verdampfertemperaturen geregelt.

Nähere Einzelheiten über den für die Abscheidung verwendeten Reaktor sind aus der deutschen Patentanmeldung P 35 18 452.3 zu entnehmen.

Durch Erhitzen der Anordnung (1, 2, 3, 6) auf 950°C wird eine Diffusion von Boratomen (siehe Pfeile 4) in das Substrat 1 erreicht, die über die Temperzeit im Bereich von 20 Minuten bis 2 Stunden mengenmäßig kontrolliert wird. Anschließend wird die BSG-Schicht 3 durch Naßätzung mit gepufferter Fluorwasserstoffsäure entfernt. Dieses Ätzverfahren hat eine hohe Selektivität gegen Silizium.

Figur 3 zeigt den Graben 6, dessen Boden und Wände nun eine definierte p-Dotierung 5 aufweisen. Die Verteilung der Boratome im dotierten Bereich 5 ist dabei äußerst gleichmäßig.

### Ansprüche

1. Verfahren zum Erzeugen einer definierten Dotierung in Seitenwänden und Böden von in Halbleitersubstrate eingeätzten Gräben durch Ausdiffusion von Dotierstoff aus einer in diesen Gräben abgeschiedenen, den Dotierstoff enthaltenden Schicht und anschließende Entfernung der Schicht, **dadurch gekennzeichnet,** daß die Schicht (3) als Borsilikatglas durch thermische Zersetzung aus der Gasphase von organischen Silizium und Sauerstoff und Bor enthaltenden Verbindungen abgeschieden wird.

2. Verfahren nach Anspruch 1, **dadurch gekennzeichnet,** daß die Schicht (3) durch Zersetzung von Tetraethylorthosilikat (TEOS) und Trimethylborat (TMB) abgeschieden wird.

3. Verfahren nach einem der Ansprüche 1 oder 2, **dadurch gekennzeichnet,** daß die Abscheidung im Temperaturbereich von 600 bis 700°C und bei einem Druck von 0,1 bis 2 mbar erfolgt.

4. Verfahren nach einem der Ansprüche 1 bis 3, **dadurch gekennzeichnet** , daß die Ausdiffusion von Bor (4) bei Temperaturen von 900 bis 1050°C erfolgt.

5. Verfahren nach Anspruch 4, **dadurch gekennzeichnet,** daß die Temperzeit zur Ausdiffusion zwischen 20 Minuten und 2 Stunden eingestellt wird.

FIG 1

FIG 2

FIG 3

# EUROPÄISCHER RECHERCHENBERICHT

Nummer der Anmeldung

EP 87 11 1271

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | WO-A-8 504 760 (AMERICAN TELEPHONE & TELEGRAPH CO.) <br> * Zusammenfassung; Ansprüche 1,2 * <br> --- | 1 | H 01 L 21/225 <br> H 01 L 21/82 |
| Y | MICROELECTRONICS JOURNAL, Band 11, Nr. 11, 1980, Seiten 21-24, Mackintosh Publications Ltd, Luton, Berk., GB; P.M. PRASAD et al.: "Diffusion of boron into silicon from doped oxide source" * Kapitel 2,3.2,3.4; Figur 1 * | 1 | |
| X | Idem | 2-4 | |
| A | Idem <br> --- | 5 | |
| A | WO-A-8 603 620 (NCR CORP.) <br> * Ansprüche 1,3,4 * <br> --- | 1,4,5 | |
| A | EP-A-0 044 400 (INTERNATIONAL BUSINESS MACHINES CORP.) <br> ----- | | |

RECHERCHIERTE SACHGEBIETE (Int. Cl.4)

H 01 L

Der vorliegende Recherchenbericht wurde für alle Patentansprüche erstellt

| Recherchenort | Abschlußdatum der Recherche | Prüfer |
|---|---|---|
| DEN HAAG | 18-11-1987 | ZOLLFRANK G.O. |